# EUROPEAN PATENT SPECIFICATION

(11) **EP 3 160 029 B1**
(45) Date of publication and mention of the grant of the patent: **09.03.2022**
(21) Application number: 16157092.4
(22) Date of filing: 24.02.2016
(51) Int. Cl.: H02M 7/00

(54) **INVERTER**
INVERTER
ONDULEUR

(30) Priority: 15.06.2015 CN 201520412624 U
(43) Date of publication of application: 26.04.2017
(60) Divisional application: 22152934.0
(73) Proprietor: Sungrow Power Supply Co., Ltd., Hefei, Anhui 230088 (CN)
(72) Inventor: DONG, Puyun, 230088 Hefei (CN); LI, Yonghong, 230088 Hefei (CN); ZHOU, Hao, 230088 Hefei (CN); MAO, Jianhua, 230088 Hefei (CN)
(74) Representative: Zacco Norway AS

(56) References cited:
- EP-A2- 0 356 991
- WO-A2-2014/114622
- GB-A- 2 385 469
- JP-A- 2000 312 484
- JP-A- 2014 090 604
- US-A- 4 772 999
- US-A- 4 772 999
- US-A1- 2012 002 452
- US-A1- 2014 321 065

## Description

### FIELD

The disclosure relates to the technical field of power electronic technology, and in particular to an inverter.

### BACKGROUND

An inverter in the conventional technology mainly includes an electronic device, a magnetic element, a heat radiator and a box. There are two common arrangements for the inverter as follows.

In one arrangement, the electronic device and the magnetic element are disposed in a box, and the heat radiator is disposed outside the box. With this arrangement, most of heat generated by the magnetic element is accumulated inside the box when the inverter operates, high heat radiation acts on the electronic device inside the box, which is easy to damage the electronic device.

In another arrangement, the electronic device is disposed inside a box, the magnetic element and the heat radiator are disposed in parallel. In addition, a fan is provided to blow the magnetic element and the heat radiator for heat radiation, the cold air blast firstly flows through the heat radiator and then passes the magnetic element. With this arrangement, the magnetic element may block the cold air blast flowed through the heat radiator, therefore the radiation effect of the heat radiator is reduced.

Hence, the radiation effects of the two common arrangements for the inverter in the conventional technology both are not good.

Fiorina et al. (US 4,772,999 A) disclosed a converter comprising a plurality of modules each having a heat-sink unit with a base-plate made of a good heat-conducting metal material, acting as a support for the electronic components, a pair of parallel flanges laterally fixed to the opposite edges of the base-plate, and a rear plate for connection of the draw-in contacts capable of cooperating with the studs of a fixed connecting base. Error prevention means, formed by pins and orifices prevent any module connection error. The draw-in contacts are achieved by tulip-fingers or grips capable of being housed in six holes of the connection plate.

Hetzroni (US 2012/002452 A1) disclosed a method of making a compact power inverter comprising: providing a plurality of transistors, a main circuit board, a transformer, an input control circuit board; an output control circuit board; and optionally, casing; aligning transistors in the plurality of transistors in rows on the top side of the main circuit board; capping the rows with heat sinks; installing the main circuit board in the casing when a casing is present, preferably in a thermally coupled configuration adapted to cool at least one of the transistors in the plurality of transistors by conduction to the casing; positioning the output control circuit board and the input control circuit board vertically between rows of the plurality of transistors; and, attaching the transformer to the bottom side of the main circuit board.

Nishimura et al. (US 2014/321065 A1) disclosed a DC-DC converter. The DC-DC converter is provided with a transformer provided with a primary coil and a secondary coil; switching elements connected to the primary coil for switching the flow of electrical current to the primary coil; rectifying elements connected to the secondary coil; a case having a first accommodating portion in which the transformer is accommodated and a second accommodating portion in which the switching elements and the rectifying elements are accommodated; and a metal heat sink mounted on the case, the metal heat sink being thermally connected to the switching elements and the rectifying elements and having a radiator portion exposed on the outer surface of the case.

WO 2014/114622 A2 discloses an inverter (1) having a first housing module (2), a second housing module (3), removably connected to the first housing module (2), and power-electronic components in both housing modules (2, 3), wherein a cooling air channel (6), opening in the surroundings (31) of the inverter (1), is delimited in the circumferential direction partially by the first housing module (2) and partially by the second housing module (3). The first housing module (2) is designed for mounting to an external structure and the second housing module (3) is designed for exclusive mounting to the first housing module (2). The cooling air channel (6) extends at a distance to a mounting plane of the inverter (1) defined by the first housing module (2) opposite the external structure.

EP 0 356 991 A2 discloses an inverter device including a main circuit section, a logic section disposed apart from said main circuit section, a shielding member disposed between said main circuit section and said logical section, and a cooling means which cools said main circuit section, said main circuit section and said logical section being so constituted as to be disposed in independent chambers by said shielding member.

### SUMMARY

In view of this, an inverter is provided according to independent claim 1, to solve the problem of poor radiation effect in the conventional technology.

An inverter is provided, which includes: an electronic device, a magnetic element, a heat radiator, a cooling fan, a first box and a second box connected with each other via a mounting plate, where the mounting plate is located between the first box and the second box; the electronic device is disposed inside the first box; the heat radiator and the cooling fan are disposed inside the second box;
the magnetic element is disposed outside the first box and the second box;
the magnetic element is disposed on a top plate of the second box;
the cooling fan is disposed on a side plate of the second box inside the second box, the side plate may be perpendicular to gaps between fins of the heat radiator; and the side plate is perpendicular to the top plate;
the first box and the second box share one mounting plate, and are located on two parallel mounting surfaces of the mounting plate respectively; one or more vents are disposed in another side plate of the second box, the another side plate is perpendicular to the gaps between the fins of the heat radiator; the side plate, the other side plate and the mounting plate are perpendicular to the top plate.

Preferably, the heat radiator may be disposed on the mounting plate inside the second box; and the electronic device may be disposed on the mounting plate inside the first box.

Preferably, the number of the vents may be more than one, and the vents may be uniformly disposed at positions corresponding to the gaps between the fins of the heat radiator.

Preferably, the number of the cooling fans may be four.

In the inverter according to the disclosure, the electronic device is disposed inside the first box; the heat radiator and the cooling fan are disposed inside the second box; and the magnetic element is disposed outside the first box and the second box. In this way, the cooling effect on the electronic device inside the first box and the heat radiator inside the second box may be less affected by the heat generated by the magnetic element. The magnetic element being disposed outside the first box and the second box is also beneficial to heat radiation of the magnetic element. The cooling fan only blows the heat radiator for heat radiation, there is not a case that the magnetic element blocks the cold air blast flowed through the heat radiator as in the conventional technology, therefore a more unobstructed air duct is formed, and the radiation effect is improved.

### BRIEF DESCRIPTION OF THE DRAWINGS

The drawings to be used in the description of embodiments of the disclosure or the conventional technology are described briefly as follows, so that technical solutions according to the embodiments of the present disclosure or according to the conventional technology become clearer. It is apparent that the drawings in the following description only illustrate some embodiments of the present disclosure. For those skilled in the art, other drawings may be obtained based on these drawings without any creative work.
Figure 1 is a schematic structural diagram of an inverter according to an embodiment of the disclosure;
Figure 2 is a schematic structural diagram of an inverter according to an embodiment of the disclosure; and
Figure 3 is a schematic structural diagram of a second box according to an embodiment of the disclosure.

### DETAILED DESCRIPTION OF EMBODIMENTS

The technical solution according to the embodiments of the disclosure is described clearly and completely as follows in conjunction with the accompanying drawings. Apparently, the described embodiments are only a part of the embodiments according to the disclosure.

An inverter is provided according to the disclosure, to solve the problem of the poor radiation effect in the conventional technology.

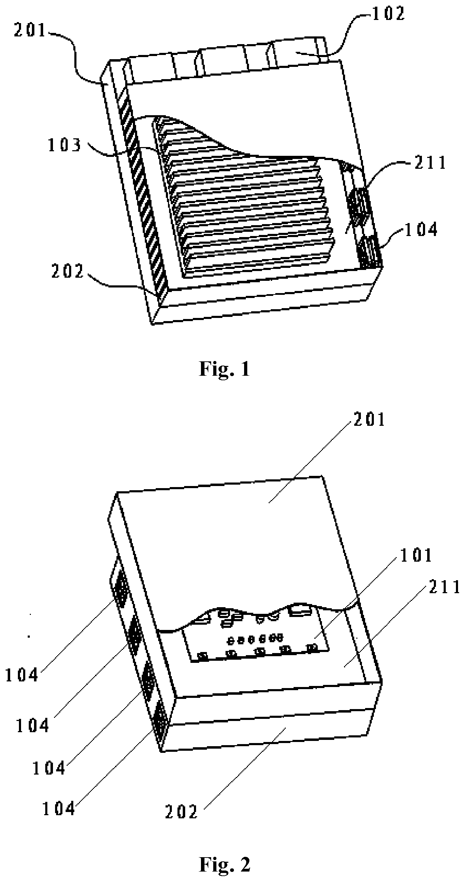

Specifically, as shown in Figure 1 and Figure 2, the inverter includes: an electronic device 101, a magnetic element 102, a heat radiator 103, a cooling fan 104, a first box 201 and a second box 202 connected with each other via a mounting plate 211, where
the mounting plate 211 is located between the first box 201 and the second box 202;
the electronic device 101 is disposed inside the first box 201;
the heat radiator 103 and the cooling fan 104 are disposed inside the second box 202; and
the magnetic element 102 is disposed outside the first box 201 and the second box 202.

The magnetic element 102 being disposed outside the first box 201 and the second box 202 may lead to a result that the cooling effect on the electronic device 101 inside the first box 201 and the heat radiator 103 inside the second box 202 is less affected by the heat generated by the magnetic element 102. The magnetic element 102 is disposed outside the first box 201 and the second box 202, and is directly contacted with outside air, the heat generated by the magnetic element 102 is easy to be exchanged with the air, hence the temperature of the magnetic element 102 is reduced, and it is beneficial to heat radiation of the magnetic element 102, the operation efficiency of the magnetic element 102 is improved. The cooling fan 104 only blows the heat radiator 103 for heat radiation, there is not a case that the magnetic element blocks the cold air blast flowed through the heat radiator as in the conventional technology, therefore a more unobstructed air duct is formed, and the radiation effect is improved.

It should be noted that, the magnetic element 102 being disposed outside the first box 201 and the second box 202 may lead to a result that the heat radiation of the electronic device 101 inside the first box 201 and the heat radiator 103 inside the second box 202 is less affected by the heat generated by the magnetic element.

In practice, each of the first box 201 and the second box 202 includes the mounting plate 211 to mount a respective device.

The first box 201 and the second box 202 share one mounting plate 211, and are located on two parallel mounting surfaces of the mounting plate 211 respectively.

The electronic device 101 and the heat radiator 103 are mounted on two parallel mounting surfaces of the mounting plate 211 respectively, and the two parallel mounting surfaces of the mounting plate 211 may be two surfaces having the largest areas. In practice, the two parallel mounting surfaces of the mounting plate 211 may be two surfaces, for mounting the devices, not having the largest areas, which is not limited herein and defined depending on specific application.

The first box 201 and the second box 202 are respectively disposed on the two parallel mounting surfaces of the mounting plate 211 so that the first box 201 and the second box 202 are connected in a back-to-back way. Taking a cuboid as an example for description, both the first box 201 and the second box 202 have five surfaces, and are mounted on a front surface and a back surface of the mounting plate 211.

The heat radiator 103 is disposed on the mounting plate 211 inside the second box 202 (as shown in Figure 1); and the electronic device 101 is disposed on the mounting plate 211 inside the first box 201 (as shown in Figure 2).

As shown in Figure 1 and Figure 2, the heat radiator 103 and the electronic device 101 are disposed at two sides of the mounting plate 211 respectively so that the heat radiator 103 and the electronic device 101 are contacted in a back-to-back way via the mounting plated 211. In this way, the heat radiator 103 can operate well for the heat radiation for the electronic device 101.

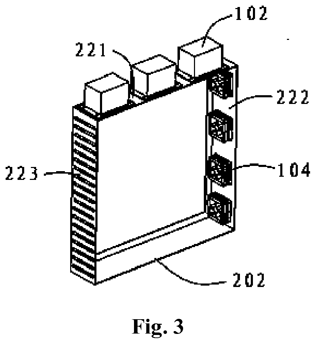

As shown in Figure 3, the magnetic element 102 is disposed on a top plate 221 of the second box 202.

A position where the magnetic element 102 is disposed is named as the top plate 221 of the second box 202, and a direction in the description is referred to a placement direction of the inverter when the inverter operates.

The magnetic element 102 is disposed on the top plate 221 of the box and is directly contacted with outside air, the heat generated by the magnetic element 102 is easy to be exchanged with the air, hence the temperature of the magnetic element 102 is reduced, and it is beneficial to heat radiation of the magnetic element 102, the operation efficiency of the magnetic element 102 is improved.

As shown in Figure 1, the cooling fan 104 is disposed on a side plate 222 of the second box 202 inside the second box 202, the side plate 222 is perpendicular to gaps between fins of the heat radiator 103.

A position of the second box 202 where the cooling fan 104 is disposed is the side plate 222 of the second box 202 perpendicular to the gaps between the fins of the heat radiator 103. In this way, it is ensured that the cold air blast generated by the cooling fan 104 can flow through the heat radiator 103 in a large area, and it is beneficial to the heat radiation of the heat radiator 103.

As shown in Figure 1, one or more vents are disposed in another side plate 223 of the second box 202, the another side plate 223 is perpendicular to the gaps between the fins of the heat radiator 103.

Preferably, as shown in Figure 1, the number of the vents is more than one, and the vents are uniformly disposed at positions corresponding to the gaps between the fins of the heat radiator 103.

The positions corresponding to the gaps between the fins of the heat radiator 103 correspond to projection of the gaps between the fins of the heat radiator 103 on the side plate 223.

The cooling fan 104 and the vents are disposed at two sides of the heat radiator 103 respectively, so that the cold air blast generated by the cooling fan 104 can pass the gaps between the fins of the heat radiator 103 and the vents, thus an unobstructed air duct can be formed, and it is beneficial to the heat radiation of the heat radiator 103.

In practice, the number and positions of the vents may depend on the specific application, which is not limited herein.

Preferably, as shown in Figure 2 and Figure 3, the number of the cooling fans 104 is four.

In practice, the number of the cooling fans 104 is not limited. The cooling fans 104 shown in the drawings show only an example, and the number of the cooling fans 104 may depend on the specific application.

The embodiments of the specification are described in a progressive manner, with the emphasis of each of the embodiments on the difference from the other embodiments. Hence, for the same or similar parts between the embodiments, one embodiment can be understood with reference to the other embodiments.

The description of the embodiments herein enables those skilled in the art to implement or use the present disclosure. Numerous modifications to the embodiments are apparent to those skilled in the art, and the general principles defined herein can be implemented in other embodiments without deviating from the scope of the present invention as defined by the appended claims.

Therefore, the present disclosure may not be limited to the embodiments described herein, but is in accordance with the widest scope consistent with the principles and novel features disclosed herein.

## Claims

1. An inverter comprising: an electronic device (101), a magnetic element (102), a heat radiator (103), a cooling fan (104), a first box (201) and a second box (202) connected with each other via a mounting plate (211), the mounting plate (211) is located between the first box (201) and the second box (202); the electronic device (101) is disposed inside the first box (201);
the heat radiator (103) and the cooling fan (104) are disposed inside the second box (202);
the magnetic element (102) is disposed outside the first box (201) and the second box (202);
the magnetic element (102) is disposed on a top plate (221) of the second box (202);
the cooling fan (104) is disposed on a side plate (222) of the second box (202) inside the second box (202), the side plate (222) is perpendicular to gaps between fins of the heat radiator (103), and
the side plate (222) is perpendicular to the top plate (221);
the first box (201) and the second box (202) share one mounting plate (211), and are located on two parallel mounting surfaces of the mounting plate (211) respectively;
wherein one or more vents are disposed in another side plate (223) of the second box (202), the another side plate (223) is perpendicular to the gaps between the fins of the heat radiator (103);
**characterized in that**
the side plate (222), the other side plate (223) and the mounting plate (211) are perpendicular to the top plate (221).

2. The inverter according to claim 1, wherein the heat radiator (103) is disposed on the mounting plate (211) inside the second box; and the electronic device (101) is disposed on the mounting plate (211) inside the first box (201).

3. The inverter according to claim 1, wherein the number of the vents is more than one, and the vents are uniformly disposed at positions corresponding to the gaps between the fins of the heat radiator (103).

4. The inverter according to claim 1, wherein the number of the cooling fans (104) is four.

## Patentansprüche

1. Inverter umfassend: eine elektronische Vorrichtung (101), ein magnetisches Element (102), einen Wärmestrahler (103), ein Kühlgebläse (104), einen ersten Kasten (201) und einen zweiten Kasten (202), die über eine Montageplatte (211) miteinander verbunden sind, indem die Montageplatte (211) zwischen dem ersten Kasten (201) und dem zweiten Kasten (202) angeordnet ist; die elektronische Vorrichtung (101) ist im ersten Kasten (201) angeordnet; wobei der Wärmestrahler (103) und das Kühlgebläse (104) im zweiten Kasten (202) angeordnet sind;
wobei das magnetische Element (102) außerhalb des ersten Kastens (201) und des zweiten Kastens (202) angeordnet ist;
wobei das magnetische Element (102) auf einer oberen Platte (221) des zweiten Kastens (202) angeordnet ist;
wobei das Kühlgebläse (104) auf einer Seitenplatte (222) des zweiten Kastens (202) im zweiten Kasten (202) angeordnet ist, indem die Seitenplatte (222) senkrecht zu Zwischenräumen zwischen Rippen des Wärmestrahlers (103) ist, und
wobei die Seitenplatte (222) zur oberen Platte (221) senkrecht ist;
wobei der erste Kasten (201) und der zweite Kasten (202) eine Montageplatte (211) teilen und jeweils auf zwei parallelen Montageflächen der Montageplatte (211) angeordnet sind;
worin eine oder mehrere Entlüftungsöffnungen in einer anderen Seitenplatte (223) des zweiten Kastens (202) angeordnet sind, indem die andere Seitenplatte (223) zu Zwischenräumen zwischen Rippen des Wärmestrahlers (103) senkrecht ist;
**dadurch gekennzeichnet, dass** die Seitenplatte (222), die andere Seitenplatte (223) und die Montageplatte (211) zur oberen Platte (221) senkrecht sind.

2. Inverter nach Anspruch 1, wobei der Wärmestrahler (103) auf der Montageplatte (211) im zweiten Kasten angeordnet ist; und die elektronische Vorrichtung (101) auf der Montageplatte (211) im ersten Kasten (201) angeordnet ist.

3. Inverter nach Anspruch 1, wobei die Anzahl von Entlüftungsöffnungen mehr als eine ist, und die Entlüftungsöffnungen in Positionen entsprechend den Zwischenräumen zwischen den Rippen des Wärmestrahlers (103) gleichmäßig angeordnet sind.

4. Inverter nach Anspruch 1, wobei die Anzahl von Kühlgebläsen (104) vier ist.

## Revendications

1. Onduleur comprenant : un dispositif électronique (101), un élément magnétique (102), un radiateur thermique (103), un ventilateur de refroidissement (104), un premier boîtier (201) et un deuxième boîtier (202) reliés l'un à l'autre via une plaque de montage (211), dans lequel la plaque de montage (211) est située entre le premier boîtier (201) et le deuxième boîtier (202) ; le dispositif électronique (101) est disposé à l'intérieur du premier boîtier (201) ;
le radiateur thermique (103) et le ventilateur de refroidissement (104) sont disposés à l'intérieur du deuxième boîtier (202) ;
l'élément magnétique (102) est disposé à l'extérieur du premier boîtier (201) et du deuxième boîtier (202) ;
l'élément magnétique (102) est disposé sur une plaque supérieure (221) du deuxième boîtier (202) ;
le ventilateur de refroidissement (104) est disposé sur une plaque latérale (222) du deuxième boîtier (202) à l'intérieur du deuxième boîtier (202), la plaque latérale (222) est perpendiculaire aux espaces entre les ailettes du radiateur thermique (103), et
la plaque latérale (222) est perpendiculaire à la plaque supérieure (221) ;
le premier boîtier (201) et le deuxième boîtier (202) partagent une plaque de montage (211), et sont situés respectivement sur deux surfaces de montage parallèles de la plaque de montage (211) ;
dans lequel un ou plusieurs évents sont disposés dans une autre plaque latérale (223) du deuxième boîtier (202), l'autre plaque latérale (223) est perpendiculaire aux espaces entre les ailettes du radiateur thermique (103) ; **caractérisé en ce que** la plaque latérale (222), l'autre plaque latérale (223) et la plaque de montage (211) sont perpendiculaires à la plaque supérieure (221).

2. Onduleur selon la revendication 1, dans lequel le radiateur thermique (103) est disposé sur la plaque de montage (211) à l'intérieur du deuxième boîtier ; et le dispositif électronique (101) est disposé sur la plaque de montage (211) à l'intérieur du premier boîtier (201).

3. Onduleur selon la revendication 1, dans lequel le nombre d'évents est supérieur à un, et les évents sont disposés uniformément à des positions correspondant aux espaces entre les ailettes du radiateur thermique (103).

4. Onduleur selon la revendication 1, dans lequel le nombre de ventilateurs de refroidissement (104) est quatre.
